**Europäisches Patentamt**

**European Patent Office**

**Office européen des brevets**

(19)

(11) Veröffentlichungsnummer: **0 090 319 B1**

# EUROPÄISCHE PATENTSCHRIFT

(45) Veröffentlichungstag der Patentschrift:
**08.10.86**

(21) Anmeldenummer: **83102804.8**

(22) Anmeldetag: **21.03.83**

(51) Int. Cl.⁴: **C 23 C 16/42, H 01 L 21/285**

(54) Verfahren zum selektiven Abscheiden von aus Siliziden hochschmelzender Metalle bestehenden Schichtstrukturen auf im wesentlichen aus Silizium bestehenden Substraten und deren Verwendung.

(30) Priorität: **30.03.82 DE 3211752**

(43) Veröffentlichungstag der Anmeldung:
**05.10.83 Patentblatt 83/40**

(45) Bekanntmachung des Hinweises auf die Patenterteilung:
**08.10.86 Patentblatt 86/41**

(84) Benannte Vertragsstaaten:
**AT CH FR GB LI NL**

(56) Entgegenhaltungen:
**US - A - 3 381 182**
**US - A - 4 180 596**
**US - A - 4 218 291**
**US - A - 4 239 819**

**JOURNAL OF THE ELECTROCHEMICAL SOCIETY, vol. 121, no. 1, Januar 1974, c.M. MELLIAR-SMITH et al. "Chemically vapor deposited tungsten for semiconductor metallizations", Seiten 289-303**

(73) Patentinhaber: **Siemens Aktiengesellschaft Berlin und München, Wittelsbacherplatz 2, D-8000 München 2 (DE)**

(72) Erfinder: **Hieber, Konrad, Dr., Aiblinger Strasse 3, D-8000 München 19 (DE)**
Erfinder: **Wieczorek, Claudia, Ing.grad., Ostpreussenstrasse 2, D-8012 Ottobrunn (DE)**

## Beschreibung

Die vorliegende Patentanmeldung betrifft ein Verfahren zum selektiven Abscheiden von aus Siliziden hochschmelzender Metalle bestehenden Schichtstrukturen auf die Teile von Substraten, die aus Silizium bestehen, wie sie insbesondere in der Dünnschicht- und Halbleitertechnik verwendet werden.

In der VLSI-Technik (= very large scale integration-Technik) wird das hochdotierte Polysilizium-Gate-Kontaktmaterial in MOS-Schaltungen durch eine niederohmigere Schichtkombination z.B. aus 300 nm dickem, dotiertem Polysilizium und 200 nm dicken Disilizid der Metalle Molybdän, Wolfram oder Tantal ersetzt. Hierbei tritt das Problem auf, diese Doppelschicht derart zu ätzen, dass an den Flanken der aus dem Disilizid bestehenden Leiterbahnen keine Stufen oder Überhänge auftreten.

Es ist bekannt, diese Anforderung durch einen zweistufigen Trockenätzprozess bzw. eine «lift-off»-Technik zu erfüllen. Dazu wird auf einen Vortrag aus den Proceedings 5th International Thin Film Congress in Herzlia (Israel) vom 21. bis 25.9.1981 von Kinsborn, Fraser und Vratny auf Seite 193 verwiesen.

Eine Vermeidung dieses komplizierten und aufwendigen Prozessschrittes würde eine Steigerung der Ausbeute und eine wesentliche Reduzierung der Fertigungskosten bewirken. Durch Verwendung des CVD(= chemical vapor deposition)-Verfahrens (= Abscheidung nach erfolgter thermischer Zersetzung einer gasförmigen Verbindung aus der Gasphase) ist es möglich, Wolfram partiell auf Silizium und nicht auf $SiO_2$ abzuscheiden (siehe C.M. Melliar-Smith et al., Journal of Electrochem. Soc. Vol. 121, Nr. 2, Seiten 298 bis 303, insbesondere Seite 299). Damit ergibt sich die Möglichkeit, das dotierte Polysilizium nach den bisher bekannten Verfahren problemlos zu strukturieren und anschliessend nur diese Polysilizium-Leiterbahn mit Wolfram zu belegen. Voraussetzung dafür ist jedoch, dass alle Gebiete, die nicht beschichtet werden sollen, mit $SiO_2$ belegt sind. Der Nachteil bei diesem speziellen Verfahren ist, dass Wolfram flüchtige Oxide bildet, so dass eine Schutzschicht aufgebracht werden muss. Ferner regiert Wolfram bei Temperaturen über 600°C mit der Siliziumunterlage, wobei sich eine unerwünschte Zerklüftung der Schichtoberfläche ergibt.

Da bei vielen VLSI-Prozessen Temperaturen bis zu 1100°C eingesetzt werden, können die Vorteile einer selektiven Abscheidung der Siliziumleiterbahnen mit Wolfram nicht genutzt werden. Ausserdem hat sich herausgestellt, dass Tantalsilizid in bezug auf Haftfestigkeit und Oxidierbarkeit dem Wolframsilizid überlegen ist und bei höheren Temperaturen eine $SiO_2$-Passivierungsschicht bildet.

Aufgabe der vorliegenden Erfindung ist es daher, ein Verfahren zur selektiven Abscheidung von Tantal-, Molybdän- und Wolframsilizid auf die Teile von Substraten, die aus Silizium bestehen anzugeben, wobei eine Stabilität dieser Silizide gegenüber Sauerstoff auch bei höheren Temperaturen gewährleistet ist, und bei dem die so erzeugten Silizide auch bei Temperaturen über 600°C nur eine geringe Neigung zeigen, mit der Siliziumunterlage zu reagieren. Ausserdem soll durch das Verfahren der Fertigungsprozess von VLSI-Schaltungen in bezug auf die Erzeugung der Kontaktleiterbahnebene wesentlich vereinfacht und dadurch die Ausbeute an funktionsfähigen Bauelementen gesteigert werden.

Die erfindungsgemässe Aufgabe wird durch ein Verfahren der eingangs genannten Art dadurch gelöst, dass die Metallsilizide durch thermische Zersetzung von Silizium- und das hochschmelzende Metall enthaltenden Halogenverbindungen aus der Gasphase abgeschieden werden, wobei ein Halogenwasserstoff, wie Chlor-, Brom- oder Jodwasserstoff enthaltendes oder abspaltendes Reaktionsgas verwendet wird, und der Druck, die Abscheidetemperatur und die Zusammensetzung des Reaktionsgases auf Werte eingestellt werden, bei denen bei der Abscheidung aus der Gasphase durch die Anwesenheit des Halogenwasserstoffs mit Ausnahme der aus Silizium bestehenden Bereiche des Substrats eine Keimbildung in den anderen Bereichen unterdrückt wird.

Dabei liegt es im Rahmen des Erfindungsgedankens, dass die Abscheidung aus der Gasphase mit bei der thermischen Zersetzung Halogenwasserstoff abspaltenden Silanen erfolgt oder dass während der Abscheidung aus der Gasphase dem Reaktionsgas Halogenwasserstoff beigemischt wird. Das Reaktionsgas kann auch zusätzlich mit Wasserstoff und/oder Edelgasen verdünnt werden.

Gemäss einem Ausführungsbeispiel nach der Lehre der Erfindung wird das Mischungsverhältnis des aus Metallhalogenid ($MeCl_x$), Wasserstoff ($H_2$) und einer halogenierten Silanverbindung ($SiH_{4-n}Cl_n$, wobei n = 1 bis 4) bestehenden Reaktionsgases bei einer Substrattemperatur im Bereich von 450 bis 900°C, bei einem Gesamtdruck im Bereich von 50 bis 1000 Pa auf 1 ($MeCl_x$):10($H_2$):2($SiH_{4-n}Cl_n$) eingestellt.

Weitere Ausgestaltungen der Erfindung ergeben sich aus den Unteransprüchen.

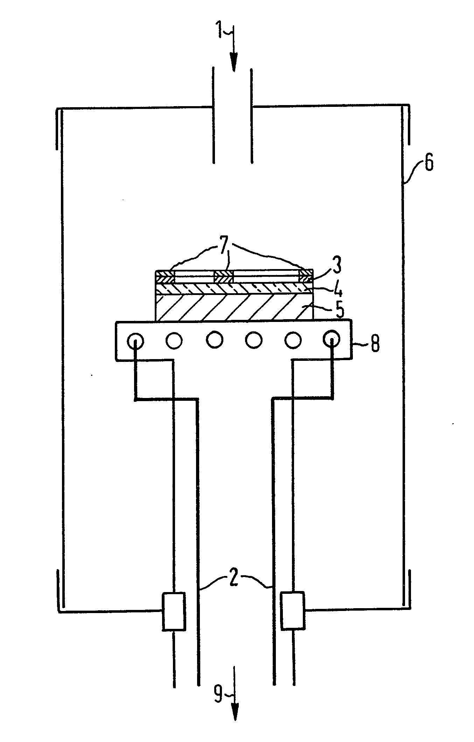

Im Folgenden wird ein Ausführungsbeispiel der Erfindung anhand der in der Zeichnung befindlichen Figur, welche schematisch ein Schnittbild durch eine nach dem erfindungsgemässen Verfahren beschichtete Struktur in einem Reaktor darstellt, beschrieben. Als Ausführungsbeispiel dient die Herstellung einer aus Tantalsilizid ($TaSi_2$) bestehenden Kontaktmetall-Schicht.

Die aus einem Gemisch von 1 Volumteil Tantalpentachlorid ($TaCl_5$), 10 Volumteilen Wasserstoff ($H_2$) und/oder Edelgasen und 2 Volumteilen Dichlorsilan ($SiH_2Cl_2$) bestehende Reaktionsgasmischung (siehe Pfeil 1) wird bei einem Gesamtdruck von 133 Pa und einer durch die Beheizung 2 des Substrats (3, 4, 5) eingestellten Substrattemperatur von 850°C in einer Niederdruck-CVD-Anlage 6 thermisch zersetzt und auf dem mit einer

strukturierten Siliziumschicht 3 versehen, mit einer $SiO_2$-Schicht 4 bedeckten Siliziumsubstrat 5 niedergeschlagen. Durch die Abscheidetemperatur bedingt, wird eine Tantalsilizidschicht 7 ausschliesslich auf der Siliziumschicht 3 niedergeschlagen und nicht auf der das Siliziumsubstrat 5 bedeckenden $SiO_2$-Schicht 4. Die Aufwachsrate beträgt 100 nm/min. Dabei kann anstelle der $SiO_2$-Schicht 4 auch eine andere Isolationsschicht, wie Aluminiumoxid ($Al_2O_3$), Tantalpentoxid ($Ta_2O_5$) oder Siliziumnitrid vorliegen. Anstelle von Tantalpentachlorid kann auch Molybdänchlorid oder Wolframchlorid anstelle von Dichlorsilan auch Trichlorsilan oder Monochlorsilan verwendet werden. Die Prozessparameter ändern sich hier entsprechend dem bei der thermischen Zersetzung gebildeten Chlorwasserstoff und können leicht empirisch ermittelt werden. Sollten sich auf anderen Bereichen als den Siliziumbereichen des Substrates trotzdem sehr dünne Silizidfilme im Verlauf der Beschichtung bilden, so ist in einer Weiterbildung des Erfindungsgedankens vorgesehen, die gesamte Anordnung einem ganzflächigen Ätzprozess, beispielsweise in einer Flussäure-Salpetersäuremischung oder im Plasma zu unterwerfen. Mit dem Bezugszeichen 8 ist der Substrathalter, mit dem Pfeil 9 der Ausgang (Vakuumpumpenanschluss) der CVD-Anlage 6 bezeichnet.

Folgende Überlegungen erklären die substratspezifische und damit selektive Abscheidung der Metallsilizide: Aufgrund thermodynamischer Berechnungen müssen sich bei Temperaturen um 800°C Tantalsilizide gemäss der Reaktion $TaCl_5+2$ $SiH_2Cl_2+2.5$ $H_2 \rightarrow TaSi_2+9$ HCl, unabhängig vom Substratmaterial herstellen lassen. Dass beim Verfahren nach der Lehre der Erfindung auf zum Beispiel $SiO_2$ die Reaktion nicht bzw. extrem langsam abläuft, könnte damit zusammenhängen, dass das Reaktionsgemisch einen Überschuss an Chlor bzw. Chlorwasserstoff freisetzt, der den Reaktionsablauf in der beschriebenen Weise hemmt. Der an der Siliziumoberfläche dissoziierende Wasserstoff könnte zur Bildung von Silan beitragen, so dass an diesen Stellen eine Reaktion gemäss $TaCl_5+2$ $SiH_4 \rightarrow 2$ $TaSi_2+5$ $HCl+1.5$ $H_2$ abläuft. Diese Reaktion ist thermodynamisch extrem begünstigt und könnte somit die hohe Selektivität des erfindungsgemässen Verfahrens erklären.

## Patentansprüche

1. Verfahren zum selektiven Abscheiden von aus Siliziden hochschmelzender Metalle bestehenden Schichtstrukturen (7) auf die Teile von Substraten, die aus Silizium bestehen, wie sie insbesondere in der Dünnschicht- und Halbleitertechnik verwendet werden, durch thermische Zersetzung von Silizium- und das hochschmelzende Metall enthaltenden Halogenverbindungen und Abscheidung der Metallsilizide (7) aus der Gasphase, wobei ein Halogenwasserstoff, wie Chlor-, Brom- oder Jodwasserstoff, enthaltendes oder abspaltendes Reaktionsgas (1) verwendet wird und der Druck, die Abscheidetemperatur und die Zusammensetzung des Reaktionsgases auf Werte eingestellt werden, bei denen bei der Abscheidung aus der Gasphase durch die Anwesenheit des Halogenwasserstoffs mit Ausnahme der aus Silizium bestehenden Bereiche (3) des Substrats (5) eine Keimbildung in den anderen Bereichen (4) unterdrückt wird.

2. Verfahren nach Anspruch 1, dadurch gekennzeichnet, dass die Abscheidung aus der Gasphase mit bei der thermischen Zersetzung Halogenwasserstoff abspaltenden Silanen erfolgt.

3. Verfahren nach Anspruch 1 und/oder 2, dadurch gekennzeichnet, dass während der Abscheidung aus der Gasphase dem Reaktionsgas Halogenwasserstoff beigemischt wird.

4. Verfahren nach Anspruch 1 bis 3, dadurch gekennzeichnet, dass dem Reaktionsgas zusätzlich Wasserstoff und/oder Edelgase zugemischt werden.

5. Verfahren nach Anspruch 1 bis 4, dadurch gekennzeichnet, dass das Mischungsverhältnis des aus Metallhalogenid ($MeCl_x$), Wasserstoff ($H_2$) und einer halogenierten Silanverbindung ($SiH_{4-n}Cl_n$, wobei n = 1 bis 4) bestehende Reaktionsgas bei einer Substrattemperatur im Bereich von 450 bis 900°C, bei einem Gesamtdruck im Bereich von 50 bis 1000 Pa auf 1 ($MeCl_2$):10 ($H_2$): 2 ($SiH_{4-n}Cl_n$) eingestellt wird.

6. Verfahren nach Anspruch 5, dadurch gekennzeichnet, dass bei der Herstellung von aus Tantal- oder Molybdän-Silizid bestehenden Schichtstrukturen (7) als Reaktionsgas neben 10 Volumteilen Wasserstoff 1 Teil Tantalpentachlorid bzw. Molybdänpentachlorid und 2 Volumteile Dichlorsilan verwendet werden.

7. Verfahren nach Anspruch 1 bis 6, dadurch gekennzeichnet, dass im Anschluss an die Abscheidung aus der Gasphase ein ganzflächiger Ätzprozess, beispielsweise in einer Flussäure-Salpetersäure-Mischung oder im Plasma durchgeführt wird.

8. Verwendung des Verfahrens nach Anspruch 1 bis 7 zur Herstellung von aus Tantal-, Wolfram- oder Molybdänsilizid bestehenden Schichten als Kontaktleiterbahnen für integrierte Halbleiterschaltungen.

## Claims

1. A process for the selective deposition of layered structures (2) consisting of silicides of high melting point metals on to the parts of substrates which consist of silicon, such as are used in particular in thin-layer and semiconductor technology, by thermal decomposition of hydrogen compounds which contain silicon and the high-melting point metal, and deposition of the metal silicides (7) from the gas phase, wherein a reaction gas (1) which contains or splits off a hydrogen halide, such as hydrogen chloride, hydrogen bromide, or hydrogen iodide, is used and the pressure, the deposition temperature and the composition of the reaction gas are set at values at which, during the deposition from the gas phase, as a result of the presence of the hydrogen halide, with the exception of the regions (3) which consist of silicon of the substrate (5), nucleus formation in the other regions (4) is suppressed.

2. A process as claimed in Claim 1, characterised in that the deposition from the gas phase is effected by means of silanes which split off hydrogen halide during the thermal decomposition.

3. A process as claimed in Claim 1 and/or Claim 2, characterised in that during the deposition from the gas phase, hydrogen halide is added to the reaction gas.

4. A process as claimed in Claim 1 to 3, characterised in that the reaction gas is additionally mixed with hydrogen and/or inert gases.

5. A process as claimed in Claim 1 to 4, characterised in that the mixing proportion of the reaction gas which consists of metal halide ($MeCl_x$), hydrogen ($H_2$) and a halogenated silane compound ($SiH_{4-n}Cl_n$), where n = 1 to 4), is set at 1 ($MeCl_2$):10 ($H_2$):2 ($SiH_{4-n}Cl_n$) at a substrate temperature in the range of 450 to 900°C, and at a total pressure in the range of 50 to 1000 Pa.

6. A process as claimed in Claim 5, characterised in that in the production of layered structures (7) which consist of tantalum silicide or molybdenum silicide, in addition to 10 parts by volume of hydrogen, 1 part of tantalum pentachloride, or molybdenum chloride and 2 parts by volume of dichlorsilane are used as reaction gas.

7. A process as claimed in Claim 1 to 6, characterised in that after the deposition from the gas phase, a full-area etching operation is carried out, for example, in a hydrofluoric acid/nitric acid mixture, or in a plasma.

8. Use of the process as claimed in Claim 1 to 7 for the production of layers which consist of tantalum silicide, tungsten silicide, or molybdenum silicide, as contact conductor paths for integrated semiconductor circuits.

**Revendications**

1. Procédé de dépôt sélectif de structures à couches (7) en siliciures de métaux à point de fusion élevé sur des parties de substrats qui sont constituées de silicium, comme on en utilise notamment dans la technique à couches minces et dans la technique des semiconducteurs, par décomposition thermique de composés halogénés contenant du silicium et le métal à point de fusion élevé, et par dépôt des siliciures métalliques (7) en phase gazeuse, un gaz réactionnel (1) contenant ou libérant un acide halohydrique, comme l'acide chlorhydrique, l'acide bromhydrique ou l'acide iodhydrique, étant utilisé et la pression, la température de dépôt et la composition du gaz réactionnel étant réglées à des valeurs pour lesquelles dans le dépôt en phase gazeuse une formation de germes dans les régions (4), autres que la région (3) du substrat constitué de silicium, est supprimée par la présence de l'acide halohydrique.

2. Procédé suivant la revendication 1, caractérisé en ce qu'il consiste à effectuer le dépôt en phase gazeuse avec des silanes libérant de l'acide halohydrique lors de la décomposition thermique.

3. Procédé suivant la revendication 1 et/ou 2, caractérisé en ce qu'il consiste à mélanger, pendant le dépôt en phase gazeuse, un acide halohydrique au gaz réactionnel.

4. Procédé suivant l'une des revendications 1 à 3, caractérisé en ce qu'il consiste à ajouter en outre au mélange réactionnel de l'hydrogène et/ou des gaz rares.

5. Procédé suivant l'une des revendications 1 à 4, caractérisé en ce qu'il consiste à régler le rapport de mélange du gaz réactionnel, constitué d'un halogénure métallique ($MeCl_x$), d'hydrogène ($H_2$) et d'un composé silanique halogéné ($SiH_{4-n}Cl_n$) avec n = 1 à 4, pour une température du substrat comprise entre 450 et 900°C et pour une pression totale comprise entre 50 et 1000 Pa, à 1 ($MeCl_2$):10 ($H_2$):2 ($SiH_{4-n}Cl_n$).

6. Procédé suivant la revendication 5, caractérisé en ce qu'il consiste à utiliser, lors de la préparation de structures à couches (7) en siliciure de tantale ou en siliciure de molybdène, comme gaz réactionnel, outre 10 parties en volume d'hydrogène, 1 partie de pentachlorure de tantale ou de pentachlorure de molybdène et 2 parties en volume de dichlorosilane.

7. Procédé suivant l'une des revendications 1 à 6, caractérisé en ce qu'il consiste à effectuer, à la suite du dépôt en phase gazeuse, un processus d'attaque sur toute la surface, par exemple dans un mélange d'acide fluorhydrique et d'acide nitrique ou au plasma.

8. Application du procédé suivant l'une des revendications 1 à 7, à la préparation de couches en siliciure de tantale, en siliciure de tungstène ou en siliciure de molybdène, comme pistes conductrices de contact pour des circuits intégrés à semiconducteurs.